# EUROPEAN PATENT APPLICATION

(11) **EP 4 517 341 A1**
(43) Date of publication of application: **05.03.2025**
(21) Application number: 23193695.6
(22) Date of filing: 28.08.2023
(51) Int. Cl.: G01R 19/165, G01R 29/027, G01R 31/52

(54) **METHOD AND SYSTEM FOR MONITORING AN ELECTRIC CIRCUIT**

(71) Applicant: Siemens Aktiengesellschaft, 80333 München (DE)
(72) Inventor: Maier, Sebastian, 91330 Eggolsheim (DE); Rothbauer, Stefan, 86156 Augsburg (DE); Salecker, Jürgen, 81827 München (DE)
(74) Representative: Siemens Patent Attorneys

(57) **Abstract**

The invention describes a method for monitoring an electric circuit (C), comprising the steps:
- measuring voltage and/or current in this circuit (C),
wherein a plurality of values being recorded time-resolved in the form of a dataset (D) with a predefined time resolution,
- examining the recorded dataset (D) for a dangerous state in the circuit (C), wherein a dangerous state is defined by threshold values (L, S, T) in that at least a predefined plurality of pulses (P) occurred within a predefined time-period (T) with each pulse (P) exceeding a predefined pulse-level (L) and its slope exceeding a predefined slope (S),
- outputting data based on the examination of the dataset (D) .

The invention further describes a related system.

## Description

The invention pertains to a method and a system for monitoring an electric circuit, especially for monitoring the occurrence of sparks in this circuit. Preferably, the invention pertains to a method for adaptive spark-detection in AC-circuits.

Rapid increases of current and/or the occurrence of sparks (or arcs) in an electrical circuit in a residential building, factory or other building could lead to dangerous situations, but could not be accurately detected until now. Sparks in particular have the potential to initiate cable fires, with potentially catastrophic consequences for an installation, an apartment or even a whole building. But also when there is no direct danger of fire, devices comprising semiconductors could be damaged by strong and fast power-fluctuations.

Concerning sparks, it has to be noted that even in an existing electrical installation that has been running without problems for many years, sparks may occur due to loosened screw terminals. These screw terminals could loosen over a long period of time (10+ years) due to temperature differences or vibrations and thus lead to a loose connection.

In contrast to permanent high current (i.e. a duration of more than 2 s), which is recognized by the usual circuit breakers after the main distribution board, very short current pulses and sparks are not recognized by the usual circuit breakers.

In the state of the art, there are known protection switches ("Arc Fault Detection Devices", AFDDs) that are available on the market. Connected serially towards an energy consumer, their function is to detect sparks. However, these devices often do provide false-positive events (reacting when there was no spark) and false-negative events (not reacting when there was a spark).

Another possible indicator could be the detection of sparks in infrared images of an installation. This method is often used on oil-rigs. However, this practice is not suitable for private use and provides only a short monitoring at a certain point of time. When there was no spark at the recording of the images, there will be no information about sparks.

It is the object of the present invention to improve the known systems, devices and methods to facilitate an improvement in monitoring an electric circuit for a dangerous state, e.g. the occurrence of sparks or other power fluctuations.

This object is achieved by a method according to claim 1 and a system according to claim 9.

A method according to the invention, for monitoring an electric circuit, preferably for monitoring sparks in this circuit, especially for adaptive spark-detection in AC-circuits, comprises the following steps:
- measuring voltage and/or current in this circuit, wherein a plurality of values being recorded time-resolved in the form of a dataset with a predefined time resolution (especially of less than 1/10 s),
- examining the recorded dataset for a dangerous state in the circuit, wherein a dangerous state is defined by threshold values in that at least a predefined plurality of pulses occurred within a predefined time-period (especially shorter than 1 h) with each pulse exceeding a predefined pulse-level (especially exceeding an average level during the predefined time-period by at least 50 %) and its slope exceeding a predefined slope (especially greater than the predefined pulse-level divided by 1 s),
- outputting data based on the examination of the dataset.

The method is able to detect a dangerous state resulting from a plurality of pulses. A dangerous state is a state where there are power fluctuations (in form of the pulses), where changes of power are above certain threshold values. These threshold values may vary with the type of consumer-elements (loads) in the respective circuit, but could then always be predefined by knowing the technical limits of the loads. However, a dangerous state may also be independent of the loads, since e.g. the danger of fire depends on an absolute power in the circuit, e.g. > 300 W or > 100W. Furthermore, the threshold should be adapted to the most sensitive consumer in the respective circuit. However, a dangerous state could also be derived from empirical values and/or derived from the most common loads (light emitters, computing elements, display elements). In short: the skilled person knows when there is a dangerous state in a circuit.

For detecting a dangerous state, voltage and/or current are measured. This means that only voltage or current could be measured or both, voltage and current or power, especially by applying a true RMS calculation, e.g. by using an ASIC. It is particularly preferred to measure current in any case and preferably additionally measure voltage for better accuracy.

This measurement is a time-resolved measurement, wherein a plurality of values is measured at certain points of time. These points of time should preferably be regular, i.e. a periodic measurement should be executed. This measurement may last over days, weeks or even years, since during this measurement dangerous stated could be detected.

The time-resolution should be sufficient to perform the following examinations (number/time, pulse-level, slope). Concerning absolute values, the time-resolution should be better than 1 s (more than 1 measurement per second or measurement frequency > 1 Hz), preferably better than 1/10 s (more than 10 measurements per second or measurement frequency > 10 Hz), especially better than 1/100 s (more than 100 measurements per second or measurement frequency > 100 Hz). The better the time resolution the more accurate the following examination. However, measurements produce data. Therefore, in order to reduce computing power, the time resolution may be lower than 1/100 ms (less than 100000 measurements per second or measurement frequency < 100 kHz), especially less than 1/10 ms (less than 10000 measurements per second or measurement frequency < 10 kHz). For example, measuring a current with a time resolution of 200 ms for 22 h or 50 ms for 2 h (during specific times, where high sparks might more likely occur) could be sufficient in practical use.

The recorded dataset is examined for the occurrence of a dangerous state in the circuit. Regarding the measured data, a dangerous state is defined by pulses in the recorded dataset, i.e. the number of pulses per time, the pulse-level and the slope of the pulses. Every pulse with a slope and a pulse-level exceeding the respective threshold value is counted. When there are certain pulses in a certain time (the respective threshold values), then a dangerous state is assumed.

When there are sparks, there will be power fluctuations embodied by pulses. These pulses may occur in a short period (multiple sparks in one second or even shorter) or in a relative long period (e.g. 30 s or longer). But also a period between 1 and 10 seconds could be advantageous.

However, there shouldn't be much false-positive cases that are detected as dangerous states, e.g. pulses of a switchingon of an electric device, pulses from a running device or noise. Therefore, the predefined plurality of pulses should preferably be more than 3, preferably more than 5, especially more than 10. However, the predefined plurality of pulses should preferably be less than 100, especially less than 20 to avoid missing dangerous states comprising some few pulses, only. So 4 to 10 pulses could be an advantageous choice for the predefined plurality of pulses.

The plurality of pulses should occur in a predefined time-period. This predefined time-period should be long enough that the plurality of pulses from sparks could occur, especially longer than 1/10 s, preferably longer than 1 s, but it could preferably also be even longer than 10 s or even 30 s. However, in order to minimize false-positives, it should be shorter than 600 s, preferably shorter than 300 s. Since a spark-event could provide multiple sparks in a very short time or one spark after the other in a long time-period, it is preferred that there are examined two events:
A first predefined plurality of pulses in a time-period of 1 s or shorter (for a "bursting spark event") and a second predefined plurality of pulses (may be equal to the first) in a time-period of 10 s or longer (for a continuous spark event). It is also preferred to increase the sample rate (time-resolution) after a "bursting spark event" has been detected for a predefined time period, e.g. selected between 1 min to 10 min, and return to the regular value again after this time period.

It should be noted that electric motors may induce pulses on currents in a circuit. Thus, not only the number of pulses is of importance, but also the height and shape of the pulses. Thus, each pulse (counted for the plurality of pulses) must exceed a predefined pulse-level. This pulse-level depends on the parameter measured. It should preferably exceed 100 W, especially 500 W, otherwise the pulse would be ignored. It should be noted that in circuits the voltage is usually well known (e.g. 230 V in Europe, 110 V in US). In the case, a current is measured, the power could be calculated by multiplying the measured current-values with the (known) voltage of the circuit. This does not give the exact value, but could be used as an approximate value for further calculations.

In addition to the pulse-level, the slope of the pulse (increase and/or decrease) must exceed a predefined slope. This slope is preferably the predefined pulse-level divided by 500 ms or more, especially the predefined pulse-level divided by 200 ms or more. It should be noted that especially the "slope" is the average slope or the maximum slope of a pulse or a slope fitted to a pulse with a known fitting method of the art.

Regarding the predefined values, any predefined value could depend from another value measured. For example, a pulse with a steep slope may be counted even if its pulse-level ls lower than the initial predefined pulse-level. Another possibility is that when there are seriously more pulses than the predefined plurality of pulses in the predefined time-period, then the predefined pulse-level may be reduced. There could also occur the case that a smaller number of higher pulses may be as dangerous as a greater number of smaller pulses. Thus, - the predefined pulse-level is preferably a value depending from the measured plurality of pulses and/or their slope and/or
the predefined slope is preferably a value depending from the measured plurality of pulses and/or their pulse-level and/or the predefined plurality of pulses is preferably a value depending from the measured pulse-level and/or slope.

Regarding the last possibility, the method may first decide whether a pulse is counted on a set of "low thresholds" and then decide based on another set of thresholds (in respect of the pulses like slope or pulse-level) whether there were a few high pulses in a time-period or many low pulses in the time-period.

The outputted data based on the examination of the dataset may be raw data comprising the result of the examination. However, it could also be the recorded dataset comprising labeled parts, wherein a label indicates parts referring to dangerous states. The outputted data may also be a warning, in the case a dangerous state is determined or even a control signal, e.g. a signal for terminating a connection of the circuit to the power grid.

It should be noted that the method up to this point is the basic method, only. In the following there are described embodiments that may be able to "learn" to avoid false-positive events, or a service detecting dangerous states in customer's circuits.

A system according to the invention, for monitoring an electric circuit, is especially designed to perform the method according to the invention. It comprises the following components:
- a sensor-unit, designed for a time-resolved measurement of voltage and/or current in this circuit, with a plurality of measured values being recorded in the form of a dataset with a predefined time resolution,
- an examination-unit, designed for examining the recorded dataset for a dangerous state in the circuit, wherein a dangerous state is defined by threshold values in that at least a predefined plurality of pulses occurred within a predefined time-period with each pulse exceeding a predefined pulse-level and its slope exceeding a predefined slope,
- an output-unit, designed for outputting data based on the examination of the dataset.

The functions of the components are described above. It should be noted that this system may be realized in one device or with several devices having a data-connection to each other.

Some units or modules of the system mentioned above can be completely or partially realized as software modules running on a processor of a respective computing system. In terms of more advanced computation requirements, i.e. for True RMS calculations, an FPGA (Field Programmable Gate Array) might be used as a co-processor for performing these computations without significantly increasing the power consumption of the device itself. The FPGA configuration (the software for the hardware) can be easily adapted to the specific environmental challenges in the similar style as the software for the micro-processor.

A realization largely in the form of software modules can have the advantage that applications already installed on an existing computing system can be updated, with relatively little effort, to install and run these units of the present application. The object of the invention is also achieved by a computer program product with a computer program that is directly loadable into the memory of a computing system, and which comprises program units to perform the steps of the inventive method, at least those steps that could be executed by a computer, when the program is executed by the computing system. In addition to the computer program, such a computer program product can also comprise further parts such as documentation and/or additional components, also hardware components such as a hardware key (dongle etc.) to facilitate access to the software.

A computer readable medium such as a memory stick, a harddisk or other transportable or permanently-installed carrier can serve to transport and/or to store the executable parts of the computer program product so that these can be read from a processor unit of a computing system. A processor unit can comprise one or more microprocessors or their equivalents.

Software could also be transformed from a computer language, e.g. "C", towards VHDL ("Very high speed integrated circuit Hardware Description Language"), via an HLS (High Level Synthesis) compiler runnable directly on an embodied FPGA, as a high performance co-processor. Thus, an FPGA could be used instead of a predefined ASIC. This offers the advantage that an FPGA configuration (or the code) is configurable as easy as classical software running on the micro-controller. Particularly advantageous embodiments and features of the invention are given by the dependent claims, as revealed in the following description. Features of different claim categories may be combined as appropriate to give further embodiments not described herein.

According to a preferred method, when detecting a dangerous state during the examination, information about the occurrence of this dangerous state is outputted. The output is especially a warning message. Alternatively (or additionally), the circuit is disconnected from a power grid and/or a number of loads (consumers) are disconnected from the circuit.

For that, a preferred System comprises an action-unit designed to output information about the presence of a dangerous state and/or designed to disconnect a circuit from a power grid and/or to disconnect a number of loads from a circuit when a dangerous state is detected.

It is preferred that there are multiple threshold values for the predefined plurality of pulses and/or the predefined time-period and/or the predefined pulse-level and/or the predefined slope, and that a certain type of dangerous state and a certain type of output is connected with a certain group of predefined values. For example, there may be three different predefined pulse-levels. If there are N pulses with the lowest level in a certain time-period, the values may only be outputted in a protocol. In the case, N pulses exceed the medium predefined pulse-level, a warning could be outputted and in the case N pulses exceed the highest predefined pulse levels, the circuit may be disconnected from the electric grid.

There could be issued a warning, in the case a state that is only protocolled occurs multiple times in a further predefined time-period (>1 h, preferably >1 d, but preferably <1 y).

It is preferred that a number of loads (electric consumers) are determined in advance (before the examination or at least before a determination of a dangerous state). These loads are those which should be disconnected in a dangerous state, in order to avoid damage, especially loads comprising semiconductor-circuits. When a dangerous state is detected, this number of loads is disconnected from the circuit. It is preferred that disconnection of a device from the circuit preferably involves a connection of the device with a stabilized power source, e.g. with an accumulator. This is especially advantageous in the case these devices are computers or servers, since it avoids loss of data.

Preferably in the case, components are disconnected, information about the disconnection is outputted.

According to a preferred method, in the course of the examination the predefined time-period is at least 10 s, especially at least 30 s. The predefined time-period should be less than 1 h, especially less than 30 minutes, since this could result in false-positive results. Preferably, the predefined plurality of pulses is at least three, especially at least 10. It is preferred that the predefined plurality of pulses is less than 100, especially less than 20 in order to avoid false-negative results.

According to a preferred method, in the course of the examination, the predefined pulse-level is at least 100 W, especially at least 300 W or even at least 500 W. This depends on the type of circuits. Generally, the predefined pulse level should be higher than 50% of the average level during the predefined time-period, especially higher than 100%.

According to a preferred method, in the course of the examination the predefined slope is the predefined pulse-level divided by 500 ms or less (time), especially 200 ms or less (time). With a predefined pulse-level of P, the slope should be steeper than P/(500ms), especially steeper than P/(200ms).

According to a preferred method, the measured voltage and/or current is transformed into a frequency space with a Fourier transformation, especially with a fast Fourier transformation. There, the number of pulses within a time-period, the pulse-level and the slope of a pulse is determined in the frequency domain. It is preferred that threshold values for determining a dangerous state in the frequency domain are defined in advance.

According to a preferred method, during the examination the amount of energy of the counted pulses is calculated and a dangerous state is additionally defined in that the pulses within the predefined time-period exceed a predefined amount of energy (additional threshold value). The energy could be determined by integrating a power-pulse or by integrating a current-pulse at a known voltage.

According to a preferred method, when a dangerous state is detected, the respective part of the dataset in which the dangerous state has been detected (i.e. that part which contains the relevant pulses) is used for training. This training could optimize the examination of the recorded dataset for a dangerous state, especially by reducing false-positive events.

On the one hand, this training may be the training of a machine-learning model. Suitable architectures are known by the skilled person, e.g. a network with fully connected layers. The input could be made by one node receiving the recorded dataset and the output may comprise several nodes for the threshold values of the desired parameters. For training, when determining a dangerous state in the recorded dataset with the method, this part of the recorded dataset is labeled to show a dangerous state. Such labeled dataset is then used to train a machine-learning model. The other parts of the recorded dataset could also be used for training, showing the "normal state".

Alternatively or additionally, it is preferred to determine the value of a parameter of the pulses (or a value for each of a plurality of parameters). The determined number of values is then examined for patterns. Alternatively, average values could be computed. For example, in the case the slope is always steeper than the predefined slope, the predefined slope may be amended to be steeper in order to reduce false-positive events. Thus, when a pattern of the slopes of recognized pulses could be determined, a better predefined slope could be established. Also, when an average could be determined, this average minus the statistical error or minus a constant value could be defined as new predefined slope. The same could be made with the predefined pulse-level or the predefined number of pulses in a predefined time-period or with a predefined pulse-energy.

Thus, it is preferred that the values are values of the one or more parameters of the group number of pulses within a time-period, pulse-level, slope of a pulse, amount of energy of a pulse and second derivative with respect to time. Preferably, based on the corresponding values of the parameters in this part of the data set, a number of threshold values for these parameters is adapted for a further automatic examination of the data set, in particular wherein the number of threshold values is one or more element of the group predefined number of pulses, predefined time-period, predefined pulse-level, predefined slope of a pulse and predefined amount of energy of a pulse.

It is preferred that the training is made dependent from certain time-periods, e.g. day and night or the seasons, wherein a plurality of threshold-sets (sets of threshold values for the examination) are determined for these time-periods.

It is preferred that the training is made dependent from certain patterns of active electric consumers (loads) connected to the circuit or turned on, wherein a plurality of threshold-sets are determined for these patterns.

A preferred system comprises a training-unit designed to use at least that part of the dataset showing a dangerous state for training the system, preferably wherein the training unit is designed for
- training a machine-learning model or
- adjusting threshold values for a number of parameters, in particular comprising parameters of the group number of pulses within a time-period, pulse-level, slope of a pulse and amount of energy of a pulse.

Concerning the training, there could also be biased "positive-labeled" events by actively amending the circuit at certain points of time and labeling these points of time as "non-dangerous events". An amendment of the circuit may be turning on and off a consumer device (load), letting a consumer device (e.g. a motor) run or plugging in and out a power supply unit of a consumer device. By labeling all non-dangerous events, the system may learn to distinguish "good" pulses from "bad" pulses. Also threshold values may be amended based on these "non-dangerous events". For example, when all these events have a certain maximum pulse-level, the predefined pulse-level may be increased (here data of dangerous states should be consulted in order to not exceed the pulse-level of dangerous states). The same may be done with the slope and/or energy of the pulses and/or the number of pulses per time-period. Non-dangerous events may preferably be filtered by using a whitelist.

According to a preferred method, voltage and/or current are measured with an induction-sensor and/or an electric field-sensor. These sensors have the advantage that they could be installed without changing the circuit. By measuring voltages, apparent power, reactive power and/or effective power could be determined.

According to a preferred method, the time resolution of the measurement is 400 ms or less, preferably 200 ms or less, especially 50 ms or less, preferably wherein voltage and/or current are measured periodically.

According to a preferred system, at least the sensor-unit and the output-unit, and in particular also an action-unit, is arranged in an electric device. This electric device is preferably a main distribution unit of a circuit or a power supply unit for connection to a circuit, such that when the device is connected to a circuit, current and/or voltage can be measured at a point of the circuit with the sensor-unit.

A preferred system that is very simple, is not able to learn and comprises threshold values for evaluation of a dangerous state as constants or functions depending from other threshold values and measured values.

Another preferred system uses the examination for dangerous states (especially of data of a simulated environment) for optimizing its threshold values. This system could be used together with the aforementioned system, especially for initially defining its threshold values or for updating its firmware.

Another preferred system comprises a machine learning model that is trained with the examined data (and labeled parts of the data indicating dangerous states).

Another preferred system comprises network interfaces designed to send data of the recorded dataset to a central computing unit examining this data. This system is especially advantageous for training, since it could examine recorded datasets of many facilities in order to detect dangerous states. It is preferred that for every facility a user may get results of the results of the measurements, preferably of course by meeting data-safety rules. However, anonymous comparisons of other datasets or averaged data may be advantageous. When the recorded datasets are very big, the examination may be done every facility and only parts of the datasets with detected dangerous states (and maybe some reference parts) could be sent to a central computing system.

A preferred system that is advantageous for the use in a household or factory comprises two modes. The first mode or "detection-mode" examines the recorded dataset for dangerous states e.g. for sparks in a monitored circuit. The sensor may be present in a fuse of the circuit, a main distributing element of this circuit or a consumer unit (load) connected to this circuit. This mode may output general information to the recorded dataset and/or warnings in the case a dangerous state has been detected in the course of the examination. It could also disconnect loads from the circuit or disconnect the circuit from a main supply grid when a dangerous state is detected.

The second mode or "training-mode" trains the system by optimizing its threshold values. This mode may be the initial mode (first training then detection) or may run parallel to the detection mode. The parts indicating a dangerous state in the dataset are examined for patterns or average values of parameters and afterwards the threshold values are either amended or new threshold values are created based on the result of this examination. The amended or new threshold values may then be used for the detection mode.

The description of the training should not be mistaken with circular reasoning, since the initial examination is optimized by the training and not installed by the training. It should be noted that in a certain circuit dangerous states (e.g. from sparks) may have a systematic steeper slope or higher level of pulses as defined by the initial threshold values. When detecting this, optimized threshold values may demand a steeper slope or a higher pulse-level in order to reduce false-positive events. In the course of the training it could eventually be detected that there are two sorts of events, maybe short events with many weak pulses in a short time-period and long events with multiple high pulses in a long time-period. The training mode may then create sets of threshold values for both types of events and the detection mode will then examine the recorded dataset in the light of the two possible types of events.

It is possible that the threshold values are predefined in a "low" manner in order to detect more possible events. However, if there is a certain pattern, in most detected events, the threshold values should be accurately fitted.

It is also preferred that initial threshold values are "lowered" in order to render the method more sensible at the beginning for the case that in a certain circuit dangerous states are indicated by lower values. When the first dangerous state is detected, the threshold values may be "risen" again by fitting them to the values of this detected state.

One advantage of the method is a cheap solution that may be easily integrated in any electric circuit.

In a preferred system according to the invention, components of the system are part of a data-network, wherein the data-network preferably comprises parts of the internet and/or a cloud-based computing system, wherein preferably the system according to the invention or a number of components of this system is realized in this cloud-based computing system. Such a networked solution could be implemented via an internet platform and/or in a cloud-based computing system.

The method may also include elements of "cloud computing". In the technical field of "cloud computing", an IT infrastructure is provided over a data-network, e.g. a storage space or processing power and/or application software. The communication between the user and the "cloud" is achieved by means of data interfaces and/or data transmission protocols.

In the context of "cloud computing", in a preferred embodiment of the method according to the invention, provision of data via a data channel (for example a data-network) to a "cloud" takes place. This "cloud" includes a (remote) computing system, e.g. a computer cluster that typically does not include the user's local machine. This cloud can be made available in particular by the medical facility, which also provides the medical imaging systems. In particular, the cloud side may be used for training and receives results of the examination step (e.g. data showing dangerous states, data showing non-dangerous states, random parts of normal data) .

Other objects and features of the present invention will become apparent from the following detailed descriptions considered in conjunction with the accompanying drawings. It is to be understood, however, that the drawings are designed solely for the purposes of illustration and not as a definition of the limits of the invention.
Figure 1 shows an electric circuit with a system according to the invention.
Figure 2 shows a box diagram of a method according to the invention.
Figure 3 shows a part of an exemplary dataset.
Figure 4 shows the implementation of the method according to the invention.

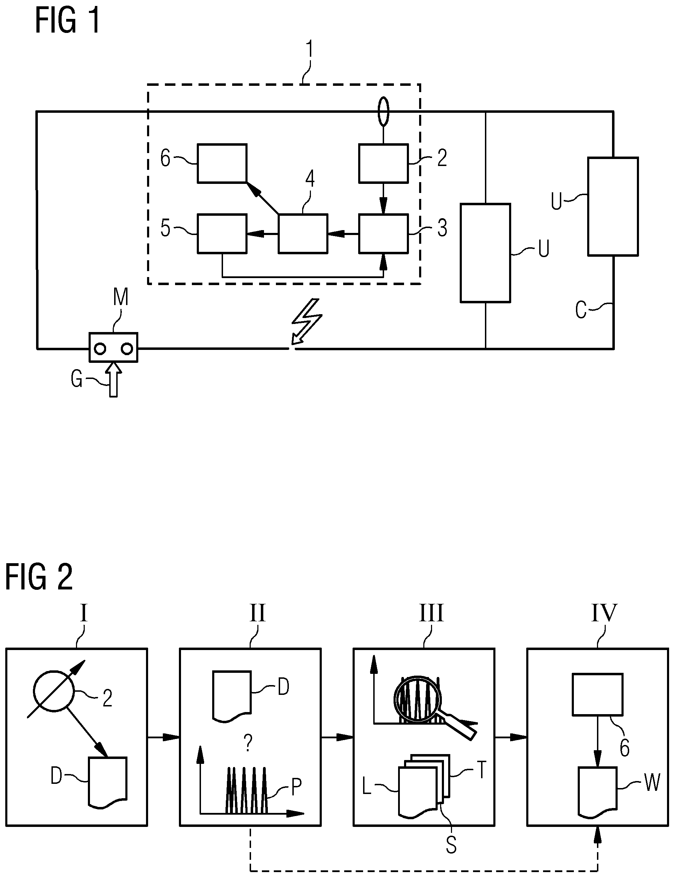

Figure 1 shows an electric circuit C with a system 1 according to the invention. The circuit C is connected to a power grid G via a main distribution unit M and comprises two consumer units U (loads U). The system 1 comprises a sensor-unit 2, an examination-unit, an output-unit and additionally a training-unit 5 and an action-unit 6.

The sensor-unit 2 is designed for a time-resolved measurement of current in the circuit C by using an induction sensor. A dataset D of measured values is recorded. The time resolution of this measurement is e.g. 10 ms.

The examination-unit 3 receives the recorded dataset D and examines it for a dangerous state in the circuit C. A dangerous state is defined by threshold values L, S, T in that at least a predefined plurality of pulses P occurred within a predefined time-period T with each pulse P exceeding a predefined pulse-level L and its slope exceeding a predefined slope S (see e.g. figure 2).

The output-unit 4 is not outputting the data based on the examination of the dataset D to a user, but to the training-unit 5 and the action unit 6.

The training-unit 5 uses the output of the output unit (labeled data of the dataset) for training the system 1, more exactly to optimize the threshold values L, S T of the examination unit 3. The training unit may train a machine-learning model or adjust the threshold values L, S, T for a number of parameters in an heuristic manner.

The action-unit 6 outputs the information about the presence of a dangerous state received from the output unit to a user. It could also be used to disconnect the circuit C from the power grid G and/or to disconnect the loads U from the circuit C when a dangerous state is detected.

In this example, the components of the system 1 are all arranged in a separate electric device. The system 1 may also be present in the main distribution unit M or in a power supply unit of one of the loads U.

Figure 2 shows a box diagram of a method for monitoring an electric circuit C, e.g. as shown in figure 1.

In step I, voltage and/or current in this circuit C is measured, wherein a plurality of values being recorded time-resolved in the form of a dataset D with a predefined time resolution.

In step II, the recorded dataset D is examined for a dangerous state in the circuit C, wherein a dangerous state is defined by threshold values L, S, T in that at least a predefined plurality of pulses P occurred within a predefined time-period T with each pulse P exceeding a predefined pulse-level L and its slope exceeding a predefined slope S.

In step III, when a dangerous state is detected, the respecttive part of the dataset D in which the dangerous state has been detected is used for training in order to optimize the examination of the recorded dataset D for a dangerous state.

This training may be performed by labeling this part of the recorded dataset D and using this labeled dataset D to train a machine-learning model. Alternatively, the value of a number of parameters of the pulses P could be determined and the determined number of values is examined for patterns. these patterns are then used to optimize threshold values L, S, T.

In step IV, when detecting a dangerous state during the examination, information about the occurrence of this dangerous state is outputted. In this example, a warning message W is sent to a user.

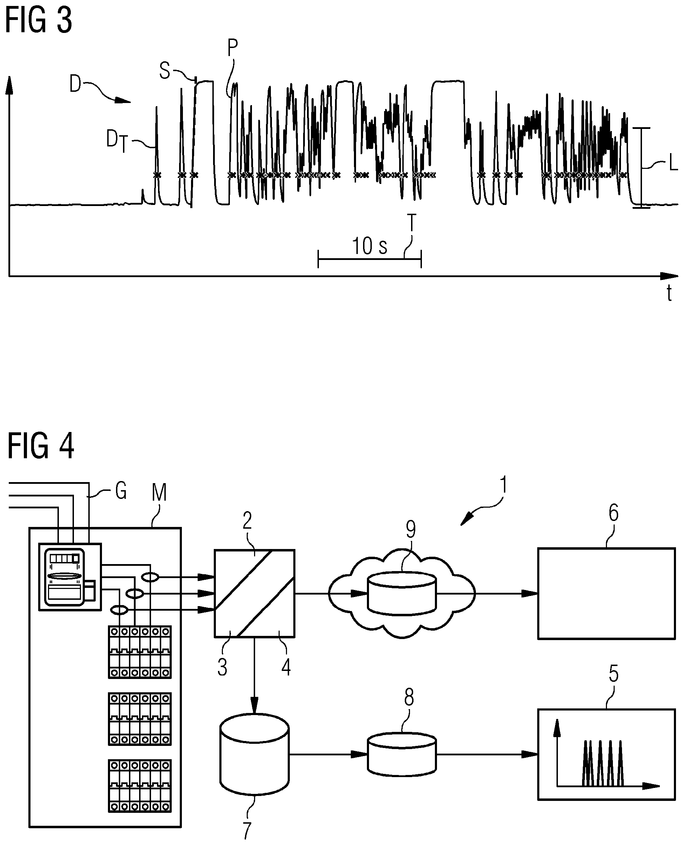

Figure 3 shows a part D_{T} of an exemplary dataset D. Here a longer spike-period occurred over several seconds. The slope and pulse-level of the pulses are determined and compared to a predefined slope S and a predefined pulse-level L. Every pulse with a slope and a pulse-level exceeding the threshold values L, S, is counted. In the case, the counted pulses (in a predefined time-period T) exceed a predefined number, then a dangerous state is assumed. In this example, a dangerous state is shown.

Figure 4 shows the implementation of the method according to the invention. As in figure 1, a main distribution unit M provides power from the power grid G to an electric circuit C (not shown here, see e.g. figure 1). The sensor-unit 2 of the system 1 records a dataset as explained above (see e.g. figures 1 and 2), the dataset is examined by an examination-unit 3 and the results are outputted by an output-unit 4.

In the upper branch, one output is sent via an MQTT broker (a protocol for machine-to-machine communication) to an action-unit 6. This action-unit 6 may be an app in a smartphone of a user receiving massages, e.g. a real-time warning message W in the case there occurred a dangerous state.

In the lower branch, one output is saved in a memory unit 7 connected to a database 8 used for a training of a training unit 5. The dataset D may be saved in a local environment or in a cloud.

Although the present invention has been disclosed in the form of preferred embodiments and variations thereon, it will be understood that numerous additional modifications and variations could be made thereto without departing from the scope of the invention. For the sake of clarity, it is to be understood that the use of "a" or "an" throughout this application does not exclude a plurality, and "comprising" does not exclude other steps or elements. The expression "a number of" means "at least one". The mention of a "unit" or a "device" does not preclude the use of more than one unit or device. The expression "a number of" has to be understood as "at least one". Independent of the grammatical term usage, individuals with male, female or other gender identities are included within the term.

## Claims

1. A method for monitoring an electric circuit (C), comprising the steps:
- measuring voltage and/or current in this circuit (C), wherein a plurality of values being recorded time-resolved in the form of a dataset (D) with a predefined time resolution,
- examining the recorded dataset (D) for a dangerous state in the circuit (C), wherein a dangerous state is defined by threshold values (L, S, T) in that at least a predefined plurality of pulses (P) occurred within a predefined time-period (T) with each pulse (P) exceeding a predefined pulse-level (L) and its slope exceeding a predefined slope (S),
- outputting data based on the examination of the dataset (D) .

2. The method according to claim 1, wherein when detecting a dangerous state during the examination, information about the occurrence of this dangerous state is outputted, especially a warning message (W), and/or the circuit (C) is disconnected from a power grid (G) and/or a number of loads (U) are disconnected from the circuit (C),
preferably wherein there are multiple threshold values (L, S, T) for the predefined plurality of pulses (P) and/or the predefined time-period (T) and/or the predefined pulse-level (L) and/or the predefined slope (S), and that a certain type of dangerous state and a certain type of output is connected with a certain group of threshold values (L, S, T).

3. The method according to any one of the preceding claims, wherein in the course of the examination
- the predefined time-period (T) is at least 10 s, especially at least 30 s and the predefined plurality of pulses (P) is at least three, especially at least 10, and/or
- the predefined pulse-level (L) is at least 100 W, especially at least 500 W, and/or
- the predefined slope (S) is the predefined pulse-level divided by 500 ms or less, especially 200 ms or less.

4. The method according to any one of the preceding claims, wherein the measured voltage and/or current is transformed into a frequency space with a Fourier transformation, especially with a fast Fourier transformation, and the number of pulses (P) within a time-period, the pulse-level and the slope of a pulse (P) is determined in the frequency domain, preferably wherein, threshold values (L, S, T) for determining a dangerous state in the frequency domain are defined in advance.

5. The method according to any one of the preceding claims, wherein during the examination the amount of energy of the recognized pulses (P) is calculated and a dangerous state is additionally defined in that the pulses (P) within the predefined time-period (T) exceed a predefined amount of energy.

6. The method according to one of the preceding claims, wherein, when a dangerous state is detected, the respective part of the dataset (D) in which the dangerous state has been detected is used for training in order to optimize the examination of the recorded dataset (D) for a dangerous state, especially by reducing false-positive events,
- wherein this part of the recorded dataset (D) is labeled to show a dangerous state and the such labeled dataset (D) is used to train a machine-learning model and/or
- wherein, the value of a number of parameters of the pulses (P) is determined and the determined number of values is examined for patterns or average values are computed, the values preferably being values of the one or more parameters of the group of threshold values comprising number of pulses (P) within a time-period, pulse-level, slope of a pulse (P), amount of energy of a pulse (P) and second derivative with respect to time and wherein based on the corresponding values of the parameters in this part of the data set, a number of threshold values (L, S, T) for these parameters is adapted for a further automatic examination of the dataset (D), in particular wherein the number of threshold values (L, S, T) is one or more element of the group predefined number of pulses (P), predefined time-period (T), predefined pulse-level (L), predefined slope (S) of a pulse (P) and predefined amount of energy of a pulse (P).

7. The method according to any one of the preceding claims, wherein voltage and/or current are measured with an induction-sensor and/or an electric field-sensor.

8. The method according to any one of the preceding claims, wherein the time resolution of the measurement is 400 ms or less, preferably 200 ms or less, especially 50 ms or less, preferably wherein voltage and/or current are measured periodically.

9. A system (1) for monitoring an electric circuit (C), comprising:
- a sensor-unit (2), designed for a time-resolved measurement of voltage and/or current in this circuit (C), with a plurality of measured values being recorded in the form of a dataset (D) with a predefined time resolution,
- an examination-unit (3), designed for examining the recorded dataset (D) for a dangerous state in the circuit (C), wherein a dangerous state is defined by threshold values (L, S, T) in that at least a predefined plurality of pulses (P) occurred within a predefined time-period (T) with each pulse (P) exceeding a predefined pulse-level (L) and its slope exceeding a predefined slope (S),
- an output-unit (4), designed for outputting data based on the examination of the dataset (D).

10. The system according to claim 9, comprising a training-unit (5) designed to use at least that part of the dataset (D) showing a dangerous state for training the system (1), preferably wherein the training unit is designed for
- training a machine-learning model or
- adjusting threshold values (L, S, T) for a number of parameters, in particular comprising parameters of the group number of pulses (P) within a time-period, pulse-level, slope of a pulse (P) and amount of energy of a pulse (P).

11. The system according to claim 9 or 10, comprising an action-unit (6) designed to output information about the presence of a dangerous state and/or designed to disconnect a circuit (C) from a power grid (G) and/or to disconnect a number of loads (U) from a circuit (C) when a dangerous state is detected.

12. The system according to any one of claims 9 to 11, wherein at least the sensor-unit (2) and the output-unit (4), and in particular also an action-unit (6) according to claim 11, is arranged in an electric device, in particular a main distribution unit of a circuit (C) or a power supply unit for connection to a circuit (C) such that when the device is connected to a circuit (C), current and/or voltage can be measured at a point of the circuit (C) with the sensor-unit (2).

13. A computer program product comprising instructions which, when the program is executed by a computer, cause the computer to carry out the steps of the method of any of claims 1 to 8.

14. A computer-readable storage medium comprising instructions which, when executed by a computer, cause the computer to carry out the steps of the method of any of claims 1 to 8.
